(19) Europäisches Patentamt
European Patent Office
Office européen des brevets

(11) **EP 2 470 921 B1**

(12) **FASCICULE DE BREVET EUROPEEN**

(45) Date de publication et mention de la délivrance du brevet:
**15.02.2017 Bulletin 2017/07**

(21) Numéro de dépôt: **10763758.9**

(22) Date de dépôt: **27.08.2010**

(51) Int Cl.:
*G01R 33/383* (2006.01)   *H01F 7/02* (2006.01)
*G01R 33/38* (2006.01)   *G01R 33/30* (2006.01)

(86) Numéro de dépôt international:
**PCT/FR2010/051782**

(87) Numéro de publication internationale:
**WO 2011/023911 (03.03.2011 Gazette 2011/09)**

(54) **DISPOSITIF D'AIMANT PERMANENT CYLINDRIQUE PRODUISANT UN CHAMP MAGNÉTIQUE CONTRÔLÉ À UNE DISTANCE DE SA SURFACE**

ZYLINDERFÖRMIGE PERMANENTMAGNETVORRICHTUNG ZUR ERZEUGUNG EINES GESTEUERTEN MAGNETFELDS IN EINEM BESTIMMTEN ABSTAND VON IHRER OBERFLÄCHE

CYLINDRICAL PERMANENT MAGNET DEVICE GENERATING A CONTROLLED MAGNETIC FIELD AT A DISTANCE FROM THE SURFACE THEREOF

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **28.08.2009 FR 0955890**

(43) Date de publication de la demande:
**04.07.2012 Bulletin 2012/27**

(73) Titulaire: **Commissariat à l'Énergie Atomique et aux Énergies Alternatives 75015 Paris (FR)**

(72) Inventeurs:
• **SAKELLARIOU, Dimitrios F-92100 Boulogne Billancourt (FR)**
• **AUBERT, Guy F-86000 Poitiers (FR)**
• **HUGON, Cédric F-92140 Clamart (FR)**

(74) Mandataire: **Desormiere, Pierre-Louis et al Cabinet Beau de Loménie 158, rue de l'Université 75340 Paris Cedex 07 (FR)**

(56) Documents cités:
**WO-A1-99/15914    WO-A2-99/05531
US-A- 5 332 971    US-A- 6 147 578
US-B1- 6 489 872**

**Description**

Domaine de l'invention

La présente invention a pour objet un dispositif d'aimant permanent cylindrique appliqué à un appareil de Résonance Magnétique Nucléaire et comprenant au moins une structure de base présentant un axe longitudinal et un ensemble de structures aimantées coaxiales en forme de couronnes non jointives ayant pour axe ledit axe longitudinal et disposées d'un même côté de la structure de base en définissant une surface extérieure perpendiculaire audit axe longitudinal pour produire un champ magnétique hors du dispositif d'aimant dans une zone d'intérêt extérieure située à une distance prédéterminée de ladite surface active le long de l'axe longitudinal.

Art antérieur

Dans le domaine de la Résonance Magnétique Nucléaire (RMN), l'échantillon (objet ou patient) est placé à l'intérieur d'un champ magnétique statique qui doit être très intense et très homogène. Il convient donc de pouvoir fabriquer des structures aimantées capables de produire de tels champs magnétiques.

Par ailleurs il est souvent utile de pouvoir produire un champ magnétique selon une direction prédéterminée. Ainsi, par exemple, selon la technique de la rotation d'échantillon à l'angle magique (en anglais « Magic Angle Sample Spinning » ou MAS) on fait tourner rapidement un échantillon à un angle dit angle magique (de 54° 44') par rapport à la direction du champ magnétique statique, afin d'améliorer la résolution.

La résolution spectrale d'un signal de RMN dépend beaucoup de la grandeur du champ magnétique statique, qui doit être la plus élevée possible, et de son homogénéité. En outre, l'intensité du signal dépend également fortement de l'intensité du champ magnétique et augmente avec celle-ci. Ainsi, pour obtenir des champs magnétiques élevés et l'homogénéité requise, les spectromètres de RMN utilisent des dispositifs coûteux pour la création d'un tel champ magnétique statique élevé et homogène.

Les aimants actuellement utilisés en RMN et en Imagerie par Résonance Magnétique (IRM) peuvent être classés en quatre catégories :

a) des aimants supraconducteurs qui sont capables de produire un champ très élevé (jusqu'à 20 à 25 T en mode continu) et très homogène. Ces aimants comprennent des bobines en matériau supraconducteur qui sont coûteuses à fabriquer et coûteuses à faire fonctionner du fait de la nécessité d'utiliser un environnement cryogénique. De tels aimants sont généralement encombrants et lourds et difficiles à transporter. De plus, la plupart de ces aimants correspondent à une configuration fermée, c'est-à-dire que l'échantillon à traiter dans le champ magnétique créé doit être placé à l'intérieur d'un tunnel à l'intérieur même de l'aimant.

b) Des électro-aimants résistifs qui sont constitués à partir de bobines conductrices classiques et étaient surtout utilisés avant la mise en oeuvre des aimants supraconducteurs. De tels électro-aimants sont moins coûteux que les aimants supraconducteurs, mais ils nécessitent beaucoup de puissance pour être activés et dissipent beaucoup d'énergie. En particulier, ils doivent la plupart du temps être refroidis à l'eau. De plus les champs créés sont limités à environ 3 T.

c) Des aimants permanents, qui sont basés sur des matériaux magnétiques durs. Leur rémanence est limitée à environ 1,4 T et leur mise en oeuvre exige des précautions pour éviter une démagnétisation. On connaît donc encore peu de systèmes à aimants permanents utilisés en RMN qui soient véritablement opérationnels et notamment de systèmes procurant l'homogénéité requise pour réaliser une spectroscopie.

d) Des aimants hybrides qui utilisent une combinaison d'électroaimants résistifs et d'aimants permanents. Ceux-ci permettent d'accroître la compacité et de réduire la quantité de courant nécessaire dans les bobines.

Ainsi, les aimants utilisés actuellement en RMN pour créer des champs intenses et homogènes sont, pour la plus grande majorité, basés sur la circulation de courant dans des bobines. Que les bobines soient résistives ou supraconductrices, il y a toujours nécessité d'approvisionner l'aimant en courant et également en fluides cryogéniques dans le cas des bobines supraconductrices. Les appareils sont de ce fait encombrants et difficilement déplaçables. Des bobines résistives nécessitent d'importantes amenées de courant, tandis que des bobines supraconductrices impliquent l'utilisation d'un cryostat rempli de liquides cryogéniques, qui est difficile à déplacer.

Très peu de structures à base d'aimant permanent ont été proposées dans le passé pour générer un champ homogène longitudinal au centre. Ceci est dû au fait que les applications RMN qui nécessitent une grande homogénéité demandent aussi aux appareils d'être soit très grands (cas de l'IRM où un corps humain doit rentrer dans l'appareil), ce qui implique une énorme quantité de matériau (plusieurs tonnes), soit très intenses (c'est le cas de la spectroscopie RMN qui utilise des champs supérieurs à 10 T, jusqu'à 20 à 25 T pour le moment), ce qui n'est tout simplement pas réalisé à l'heure actuelle avec des matériaux permanents.

Les systèmes de RMN ex-situ permettent d'effectuer des mesures de RMN en dehors de la structure du champ magnétique qui crée le champ magnétique statique. Ceci est particulièrement utile pour l'étude de sujets qui ne peuvent pas être insérés dans le tunnel d'un aimant de RMN standard. Il est souhaitable que ces systèmes puissent utiliser des aimants permanents afin d'être transportables et utilisés dans diverses applications hors d'un laboratoire.

Comme on l'a déjà indiqué, le principal problème de la RMN ex-situ réside dans la difficulté d'obtenir une homogénéité élevée dans une région d'intérêt tout en atteignant une intensité élevée dans la même région d'intérêt.

La RMN ex-situ a notamment déjà été utilisée avec des moyens relativement rudimentaires pour l'étude de matériaux poreux dans des puits de pétrole, lors du forage.

Les brevets US 6 489 872 et 6 828 892 décrivent divers concepts de RMN ex-situ basés sur des aimants permanents, mais qui ne semblent pas avoir débouché sur des applications pratiques.

La demande de brevet WO 99/05531 décrit un ensemble d'aimants permanents annulaires, qui peuvent être divisés en segments jointifs et permettent de créer un champ relativement homogène dans une région située au-dessus du système, mais on ne connaît pas à ce jour d'application pratique d'une telle structure. Les demandes de brevet WO 99/15914 et WO 00/57435 ont modifié ce concept pour l'appliquer à des systèmes symétriques hybrides comprenant deux structures annulaires se faisant face et coopérant avec deux électroaimants résistifs.

Guy Aubert avait auparavant déjà proposé dans le brevet US 5 332 971 un type de structure offrant un fort champ homogène en son centre, cette structure permettant un accès transverse à la zone utile et faisant usage de deux ensembles complémentaires d'anneaux situés de part et d'autre de la zone utile, les anneaux étant eux-mêmes divisés en segments jointifs. Un système assez voisin est également décrit dans le brevet US 5 134 374.

La demande de brevet WO 02/056047 décrit plusieurs possibilités de réalisation d'aimant créant un champ latéral, dont un mode de réalisation utilisant une paire d'aimants concentriques.

Dans le brevet US 6 657 433, il a été proposé une structure destinée à créer une homogénéité en dehors de l'aimant, mais cette structure est difficile à réaliser, car il est difficile de définir de façon contrôlée l'orientation de l'aimantation dans diverses parties d'aimant permanent.

Un système de RMN ex-situ portable à un seul côté a été proposé dans la demande de brevet WO 00/79253 et le brevet US 6 489 767, mais le système proposé n'est pas très homogène et le champ obtenu reste peu intense, de sorte qu'un tel système ne peut pas être utilisé pour une résolution spectrale.

Définition et objet de l'invention

La présente invention vise à remédier aux inconvénients mentionnés plus haut et à offrir une solution pour remédier notamment à la difficulté d'assemblage des pièces aimantées afin de former des aimants permanents puissants capables de créer un champ magnétique contrôlé et intense à une distance prédéterminée en dehors de la structure aimantée, le champ induit présentant une orientation prédéterminée par rapport à l'axe longitudinal de la structure.

L'invention vise notamment à permettre la réalisation d'appareils transportables permettant des utilisations en dehors d'un laboratoire spécialisé.

L'invention peut entre autres trouver des applications dans les domaines de la RMN "légère" ou de l'IRM.

D'une manière générale, la présente invention vise à permettre de réaliser une structure aimantée induisant un champ magnétique contrôlé à une distance de sa surface.

Ces buts sont atteints, conformément à l'invention, grâce à un dispositif d'aimant permanent cylindrique tel que défini par la revendication 1 appliqué à un appareil de Résonance Magnétique Nucléaire et comprenant au moins une structure de base présentant un axe longitudinal et un ensemble de structures aimantées coaxiales en forme de couronnes non jointives ayant pour axe ledit axe longitudinal et disposées d'un même côté de la structure de base en définissant une surface extérieure perpendiculaire audit axe longitudinal pour produire un champ magnétique hors du dispositif d'aimant dans une zone d'intérêt extérieure située à une distance prédéterminée de ladite surface extérieure le long de l'axe longitudinal, caractérisé en ce que l'une au moins des structures aimantées coaxiales en forme de couronnes est divisée en éléments constitutifs en forme de secteurs identiques non jointifs et en ce que la structure de base et l'ensemble des structures aimantées coaxiales en forme de couronnes sont aimantées selon une même direction de manière à créer dans ladite zone d'intérêt extérieure un champ magnétique induit homogène ou présentant un gradient constant, qui est orienté en formant un angle prédéterminé par rapport audit axe longitudinal.

Selon un mode de réalisation préférentiel, ledit angle prédéterminé est nul et tous les éléments constitutifs en forme de secteurs sont aimantés selon ledit axe longitudinal.

La structure de base peut être cylindrique à section circulaire, mais peut aussi présenter une forme prismatique.

La structure de base peut être divisée en secteurs contigus identiques.

Selon un mode de réalisation avantageux, l'ensemble de structures aimantées coaxiales comprend une première structure centrale, une structure intermédiaire divisée en secteurs identiques non jointifs régulièrement répartis et une structure extérieure divisée en secteurs identiques non jointifs régulièrement répartis.

A titre d'exemple non limitatif, les structures aimantées coaxiales divisées en secteurs non jointifs comprennent chacune douze secteurs, mais pourraient également comprendre un nombre de secteurs inférieur, par exemple égal à dix ou même moins, qui fournit des résultats acceptables, ou encore un nombre de secteurs supérieur à douze si l'on souhaite accroître encore l'homogénéité.

Les diverses structures aimantées coaxiales divisées en secteurs non jointifs peuvent présenter dans le sens de l'axe longitudinal des épaisseurs différentes.

De même, les diverses structures aimantées coaxiales divisées en secteurs non jointifs peuvent présenter des positionnements à des niveaux différents le long de l'axe longitudinal.

La première structure centrale peut constituer un plot central monobloc qui est cylindrique à section circulaire ou à section polygonale.

La première structure centrale peut également être réalisée en forme de couronne divisée en secteurs identiques non jointifs régulièrement répartis.

Les secteurs non jointifs des diverses structures aimantées annulaires peuvent présenter une forme trapézoïdale.

Le dispositif selon l'invention peut être adapté pour créer un champ magnétique à gradient constant ou un champ magnétique homogène.

La structure de base peut comprendre du côté de la surface extérieure active une partie centrale en retrait dans laquelle est disposée au moins une structure aimantée coaxiale en forme de couronne divisée en éléments constitutifs en forme de secteurs non jointifs, de manière à créer dans ladite zone d'intérêt extérieure un champ magnétique induit homogène.

La structure de base et l'ensemble des structures aimantées coaxiales peuvent être réalisées notamment en l'un des matériaux constitués par NdFeB et SmCo.

Le dispositif selon l'invention qui est appliqué à un appareil de Résonance Magnétique Nucléaire offre notamment la possibilité de résolution spectrale, spatiale et de mesure du temps de relaxation.

Brève description des dessins

D'autres caractéristiques et avantages de l'invention ressortiront de la description suivante de modes particuliers de réalisation donnés à titre d'exemples, en référence aux dessins annexés, sur lesquels :

- les figures 1A et 1B sont des vues schématiques d'ensemble en perspective d'un dispositif d'aimant permanent cylindrique selon l'invention, avec deux orientations différentes du champ magnétique créé,
- la figure 2 est une vue de dessus montrant une forme possible de structure polygonale d'une structure aimantée centrale utilisable dans un dispositif selon l'invention,
- la figure 3 est une vue de dessus montrant une forme possible de structure en éléments constitutifs non jointifs d'une structure aimantée intermédiaire utilisable dans un dispositif selon l'invention,
- la figure 4 est une vue de dessus montrant une forme possible de structure en éléments constitutifs non jointifs d'une structure aimantée extérieure utilisable dans un dispositif selon l'invention,
- la figure 5 est une vue en perspective d'un premier exemple de réalisation d'un dispositif d'aimant permanent cylindrique selon l'invention à gradient constant et avec une structure de base cylindrique à section polygonale,
- la figure 6 est une vue en perspective d'un deuxième exemple de réalisation d'un dispositif d'aimant permanent cylindrique selon l'invention à gradient constant et avec une structure de base cylindrique à section circulaire,
- la figure 7 est une vue en perspective d'un troisième exemple de réalisation d'un dispositif d'aimant permanent cylindrique selon l'invention à champ homogène créé en dehors du dispositif.
- la figure 8 montre les variations selon deux directions de l'induction $B_0$ du champ magnétique moins la valeur du champ produit par son gradient constant, au voisinage du centre d'homogénéité créé par un dispositif conforme à la figures 5 ou à la figure 6,
- la figure 9 montre la variation, selon l'axe de symétrie du dispositif, de l'induction $B_0$ du champ magnétique au voisinage du centre d'homogénéité créé par un dispositif conforme à la figures 5 ou à la figure 6,
- la figure 10 montre les variations selon deux directions de l'induction $B_0$ du champ magnétique au voisinage du centre d'homogénéité créé par un dispositif conforme à la figure 7, et
- la figure 11 montre la variation, selon l'axe de symétrie du dispositif, de l'induction $B_0$ du champ magnétique au voisinage du centre d'homogénéité créé par un dispositif conforme à la figure 7.

Description détaillée des modes de réalisation préférentiels

D'une façon générale, la présente invention concerne un mode d'assemblage de manière essentiellement axisymétrique ou quasi-axisymétrique des pièces aimantées afin de créer un champ magnétique arbitrairement homogène dans une zone d'intérêt à une distance prédéterminée de la structure constituée par l'assemblage des aimants.

Le profil du champ magnétique induit peut être arbitrairement choisi et être notamment constant ou à gradient constant. La position de la zone d'intérêt peut également être arbitrairement choisie le long de l'axe de symétrie du système. Le champ obtenu peut être rendu arbitrairement homogène en choisissant le nombre et les dimensions des éléments en respectant certaines règles générales qui seront rappelées ci-dessous. Une telle structure est particulièrement intéressante pour la RMN et l'IRM.

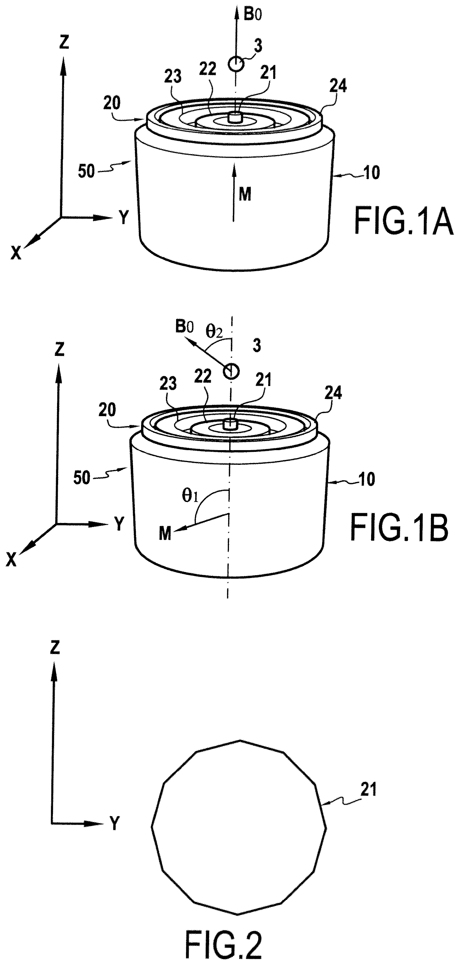

Si l'on considère les figures 1A et 1B, on voit une structure aimantée axisymétrique 50 d'axe z qui comprend un support 10 en matériau magnétique sur lequel est disposé un ensemble 20 d'anneaux coaxiaux 21, 22, 23, 24 en matériau magnétique qui sont alignés selon le même axe longitudinal z. Toutes les pièces magnétiques sont aimantées selon la même direction (voir le vecteur d'aimantation M sur les figures 1A et 1B), cette direction pouvant être l'axe longitudinal z de la structure (Figure 1A) ou une direction formant un angle $\theta_1$ non nul par rapport à cet axe z (Figure 1B). Le centre de la région d'intérêt 3 où doit être créé un champ $B_0$ dont l'homogénéité est choisie est situé sur l'axe z à une distance donnée de la surface supérieure de la structure 50. La figure 1A montre le vecteur du champ magnétique $B_0$ orienté selon l'axe z tandis que la figure 1B montre le vecteur du champ magnétique $B_0$ faisant un angle $\theta_2$ non nul par rapport à l'axe z.

Les anneaux 21 à 24 peuvent avoir des épaisseurs égales ou différentes et peuvent être situés au même niveau ou à des niveaux différents par rapport à la surface supérieure du support 10. Les dimensions et les positions relatives des anneaux sont calculées de manière à définir l'homogénéité souhaitée. Ces calculs sont basés sur une méthode analytique qui vise à éliminer les termes du développement en harmoniques sphériques du champ au centre de la région d'intérêt 3. La symétrie de rotation permet d'éliminer les termes non axiaux du développement tandis que l'assemblage des anneaux 21 à 24 et du support 10 permet d'éliminer les termes axiaux souhaités du développement.

On notera par ailleurs que si l'on fait tourner la structure après son assemblage, les inhomogénéités résiduelles se compensent en partie par un effet de moyenne et il est possible d'améliorer d'un ordre de grandeur l'homogénéité statique.

Selon l'invention, l'une au moins des structures aimantées coaxiales 21 à 24 en forme de couronnes non jointives est divisée en éléments constitutifs en forme de secteurs non jointifs.

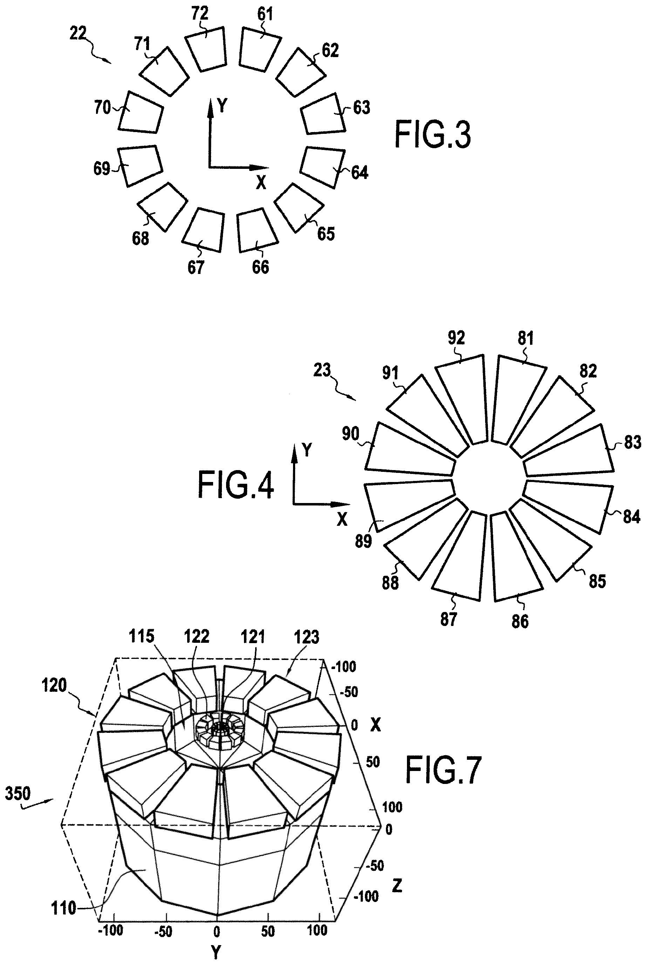

A titre d'exemple, avec un ensemble de trois couronnes coaxiales 21 à 23, on voit sur la figure 3, une couronne médiane 22 divisée en éléments constitutifs en forme de secteurs non jointifs repérés par les numéros de référence 61 à 72. L'invention n'est toutefois pas limitée à un nombre de secteurs égal à 12 et ce nombre pourrait être différent de 12, par exemple égal à 10 ou 11 ou encore supérieur à 12 si l'on souhaite accroître l'homogénéité.

De façon similaire, on voit sur la figure 4, une couronne extérieure 23 divisée en éléments constitutifs en forme de secteurs non jointifs repérés par les numéros de référence 81 à 92, dont le nombre est également de préférence supérieur ou égal à 10 et par exemple égal à 12 comme représenté sur la figure 4.

Dans cet exemple, la couronne centrale 21 est en fait constituée par un plot unique, qui peut être cylindrique ou prismatique comme représenté sur la figure 2.

D'une manière générale, il est avantageux de réaliser chaque structure cylindrique annulaire sous la forme d'une structure polyédrique régulière comprenant un ensemble de N segments identiques. Chaque segment est ainsi un prisme droit de section trapézoïdale isocèle et son aimantation est parallèle à la hauteur du prisme ou formant un angle prédéterminé par rapport à cette hauteur.

Chaque segment élémentaire en forme de secteur peut être ou non contigu par rapport aux segments voisins. Toutefois, selon la présente invention, afin de ménager des possibilités d'ajustement après assemblage, au moins une couronne 22 ou 23 est réalisée avec des segments non jointifs au sein d'une même couronne comme représenté sur les figures 3 et 4.

On décrira brièvement ci-dessous quelques notions de base utiles à la compréhension de l'invention.

Dans la plupart des cas, la région d'intérêt (RoI) est en dehors de la région des sources de champ magnétique et l'on peut définir un potentiel magnétique pseudo-scalaire tel que :

$$\vec{B} = -\vec{\nabla}\Phi^*$$

Ce potentiel vérifie l'équation de Laplace:

$$\Delta\Phi^* = 0$$

Dans le cas qui nous intéresse, on peut représenter la région d'intérêt comme une sphère dont le centre sera appelé l'origine. L'équation de Laplace peut s'exprimer dans un système de coordonnées sphériques et l'on peut obtenir un développement unique du potentiel en harmoniques sphériques, centré sur l'origine. La solution générale pour le potentiel peut alors s'écrire :

$$\Phi^*(r,\theta,\phi) = \sum_{l=0}^{\infty} \sum_{m=-l}^{l} \left[ A_{lm} r^l + B_{lm} r^{-(l+1)} \right] Y_{lm}(\theta,\phi),$$

où:

$$Y_{lm}(\theta,\phi) = \sqrt{\frac{2l+1}{4\pi} \frac{(l-m)!}{(l+m)!}} P_l^m(\cos\theta) \exp(im\phi)$$

On peut retenir que le potentiel existe seulement dans les zones vides de l'espace. On peut diviser l'espace en deux zones où le potentiel existe : à l'intérieur de la plus grande sphère centrée sur l'origine qui ne contient aucune source et à l'extérieur de la plus petite sphère centrée sur l'origine qui contient toutes les sources.

Lorsque les sources sont situées à l'extérieur de cette sphère, on peut écrire le développement de la façon suivante :

$$\Phi^*(r,\theta,\phi) = \frac{1}{\mu_0} \left\{ Z_0 + \sum_{n=1}^{\infty} r^n \left[ Z_n P_n(\cos\theta) + \sum_{m=1}^{n} \left( X_n^m \cos(m\phi) + Y_n^m \sin(m\phi) \right) P_n^m(\cos\theta) \right] \right\}$$

Où les termes $Z_n$ sont appelés les termes axiaux et les termes $X_n^m$ et $Y_n^m$ sont appelés les termes non-axiaux.

A partir de cette équation, on peut conclure que pour obtenir un champ homogène, il faut trouver une distribution de la source qui crée un potentiel pour lequel le développement ne contient que le terme $Z_1$ (dès lors que le champ est la dérivée du potentiel et que le terme $Z_0$ pour le champ correspond au terme $Z_1$ pour le potentiel). Ceci est impossible au sens strict, mais on peut supprimer autant de termes que nécessaire pour obtenir l'homogénéité désirée dans un rayon r donné puisque le champ varie comme $\left(\frac{r}{a}\right)^n$ - où a est une constante caractéristique de la géométrie. En conclusion, pour obtenir l'homogénéité souhaitée, il faut supprimer les k premiers ordres jusqu'à ce que $\left(\frac{r}{a}\right)^{k+1}$ soit suffisamment petit.

De cette équation on peut aussi déduire qu'une structure axisymétrique est avantageuse dans la mesure où elle supprime les termes non axiaux. Si l'on veut obtenir une homogénéité de l'ordre n, la symétrie de rotation en n garantit qu'aucun terme non axial n'existe avant l'ordre n.

Une fois que les termes non axiaux ont été éliminés, il reste les termes axiaux.

Il est possible d'éliminer arbitrairement les ordres p en agençant p+1 sources indépendantes.

Une optimisation non-linéaire est ainsi possible. Par ailleurs la solution trouvée est extensible. Le système peut être étendu de façon uniforme dans toutes les dimensions (de façon homothétique) et peut être rendu aussi grand que possible, les propriétés d'homogénéité n'étant pas affectées et l'amplitude du champ magnétique restant constante.

On peut montrer que les propriétés d'homogénéité du champ généré par une structure calculée comme précédemment varient de manière parfaitement prédictible si l'aimantation de toutes les pièces est inclinée dans une direction donnée. On se rend compte que lorsque l'on part d'une structure symétrique permettant de supprimer les termes non-axiaux jusqu'à l'ordre n, la composante orthogonale de l'aimantation introduite par l'inclinaison engendre des termes non-axiaux à partir de l'ordre n-2. Par ailleurs, le champ résultant voit son module diminuer et sa direction s'incliner.

Il existe des situations, notamment en RMN où il peut être utile d'avoir un champ magnétique à un angle avec l'axe de symétrie. Par exemple, les bobines spirales ne peuvent pas être utilisées aisément pour une orientation du champ pointant parallèlement à l'axe géométrique du cylindre. Avec l'inclinaison du champ, ce type de bobines devient utilisable. On peut relier l'inclinaison $\theta_2$ du champ avec l'axe de symétrie à l'inclinaison $\theta_1$ de l'aimantation avec l'axe de symétrie par les formules suivantes :

$$\sin\theta_1 = \frac{2\sin\theta_2}{\sqrt{1+3\sin^2\theta_2}}, \quad \cos\theta_1 = -\frac{\cos\theta_2}{\sqrt{1+3\sin^2\theta_2}}$$

$$\sin\theta_2 = \frac{\sin\theta_1}{\sqrt{1+3\cos^2\theta_1}}, \quad \cos\theta_2 = -\frac{2\cos\theta_1}{\sqrt{1+3\cos^2\theta_1}}$$

On peut ainsi déterminer aisément l'inclinaison de l'aimantation pour donner celle désirée au champ. Ceci peut se révéler particulièrement utile en RMN des matériaux anisotropes. L'inclinaison du champ, à l'angle magique ($\theta_2$ ≈54.7°), doublée de la rotation de l'aimant sur son axe permettrait d'améliorer la résolution de la même manière que la technique MAS. Ceci est avantageux dans la mesure où il n'est plus nécessaire de faire tourner l'échantillon et où cela permet d'analyser des sujets fragiles (par exemple vivants) ou volumineux avec une haute résolution.

Dans la pratique, les pièces en matériau magnétique ne sont pas parfaites et comportent certaines hétérogénéités et leur assemblage conduit à certaines démagnétisations non homogènes au sein des diverses pièces. Il convient donc de pouvoir procéder à des ajustements par rapport aux configurations définies de façon théorique et il est important que la structure d'ensemble soit conçue pour permettre de réaliser facilement de tels ajustements. Le dispositif selon l'invention, grâce à ses couronnes concentriques non jointives dont l'une au moins est divisée en secteurs non jointifs permet précisément de tels ajustements.

Si l'on considère que les imperfections correspondent à de faibles perturbations par rapport au résultat théorique et que le problème peut être linéarisé en termes de déplacement des différentes pièces constitutives, on peut déplacer les différentes pièces constitutives de chaque anneau divisé et évaluer l'effet de petits déplacements sur chaque pièce. A partir de là, on peut en déduire les déplacements requis pour corriger les imperfections. On peut naturellement procéder de façon itérative selon ce procédé jusqu'à atteindre les performances souhaitées.

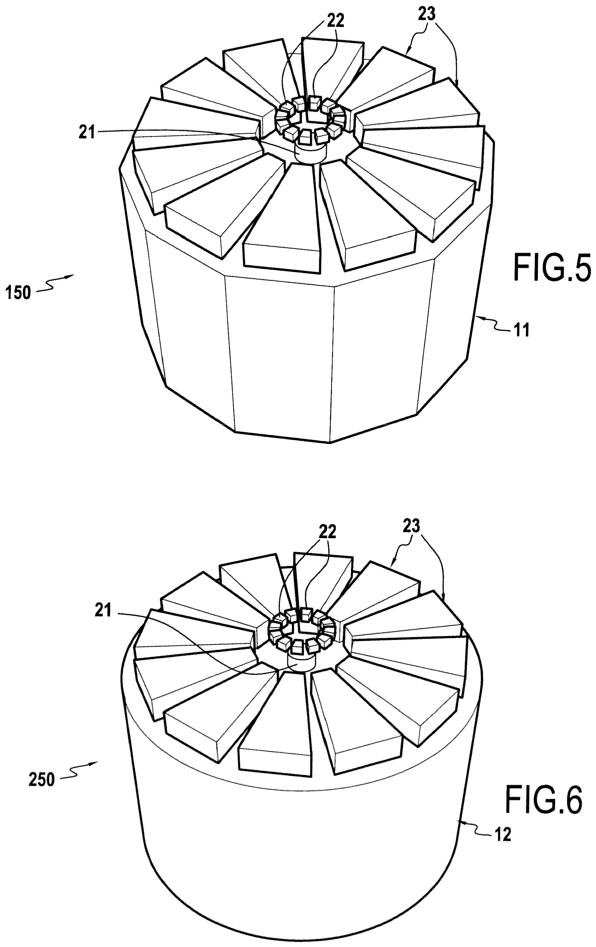

Les structures des modes de réalisation des figures 5 à 7 mettent en application ce qui précède.

Les figures 5 et 6 montrent deux variantes de réalisation d'un dispositif d'aimant constituant un système générant un champ magnétique à gradient constant.

A titre d'exemple, une zone d'intérêt optimale peut être située par exemple à 2 cm au-dessus de la surface supérieure du dispositif d'aimant et peut présenter un champ à gradient constant dans une sphère de 1 cm de diamètre avec une variation de quelques ppm (parties par million).

Comme on peut le voir sur les figures 5 et 6, trois anneaux concentriques 21, 22, 23 sont disposés au-dessus d'un support de base 11 respectivement 12 pour constituer le dispositif d'aimant 150 respectivement 250. Les différentes pièces peuvent présenter une forme cylindrique à section circulaire, plus facile à fabriquer ou une forme prismatique qui peut simplifier les calculs. Ces modes de réalisation peuvent conduire aux mêmes performances, mais les calculs sont légèrement différents.

Dans le cas du mode de réalisation de la figure 5, on a représenté une structure d'ensemble essentiellement prismatique avec un support de base 11 prismatique et des anneaux coaxiaux intermédiaire 22 et externe 23 qui sont également prismatiques, mais constitués de secteurs disjoints, en forme de trapèze. La pièce centrale 21 monobloc peut au choix être cylindrique, comme représenté sur la figure 5 ou prismatique comme représenté sur la figure 2.

Dans le cas du mode de réalisation de la figure 6, on a représenté une structure d'ensemble 250 similaire à la structure 150 de la figure 5, mais avec un support de base 12 cylindrique afin de faciliter la fabrication. Là encore, l'anneau central 21 peut être monobloc et ne pas présenter d'orifice central et peut être au choix cylindrique ou prismatique.

Dans les exemples des figures 5 et 6, les anneaux 22 et 23 comprennent douze secteurs individuels, des espaces libres étant ménagés à la fois entre les secteurs d'un même anneau et entre les différents anneaux pour permettre des réglages et ajustements aisés et fins.

Le nombre de douze secteurs par anneau constitue un mode de réalisation préférentiel avec un ordre d'homogénéité satisfaisant. Un nombre de secteurs inférieur, par exemple dix secteurs ou même moins, permet également des résultats utiles, mais avec une homogénéité légèrement dégradée. Si l'on souhaite améliorer encore plus l'homogénéité, on peut diviser les anneaux 22, 23 en plus de douze secteurs.

Les différentes pièces magnétiques peuvent être par exemple en NdFeB ou SmCo qui présentent une rémanence élevée et une haute coercivité, tandis que leur champ anisotrope est également très élevé. Toutefois, l'invention n'est pas limitée à ce type de matériau. Toutes les pièces sont aimantées selon la même direction, en général l'axe z de symétrie de la structure, ce qui simplifie la réalisation.

Les anneaux coaxiaux 21, 22, 23, 24 dont le nombre est de préférence égal à trois ou quatre sans que ceci soit limitatif peuvent présenter la même épaisseur et être situés au même niveau sur la face transversale supérieure du support de base 10, 11, 12 ou présenter des épaisseurs différentes ou encore être décalés en hauteur selon l'axe z.

A titre d'exemple, il peut être plus facile de régler la position des différentes pièces de l'anneau intermédiaire 22 si le plan de cet anneau est surélevé par rapport aux anneaux voisins, comme représenté sur les figures 5 et 6, car l'accès aux différentes pièces est facilité.

Les structures présentées à titre d'exemple éliminent les termes du développement en harmoniques sphériques des ordres 2, 3, 4 et 5 et sont donc dominées par l'ordre 6.

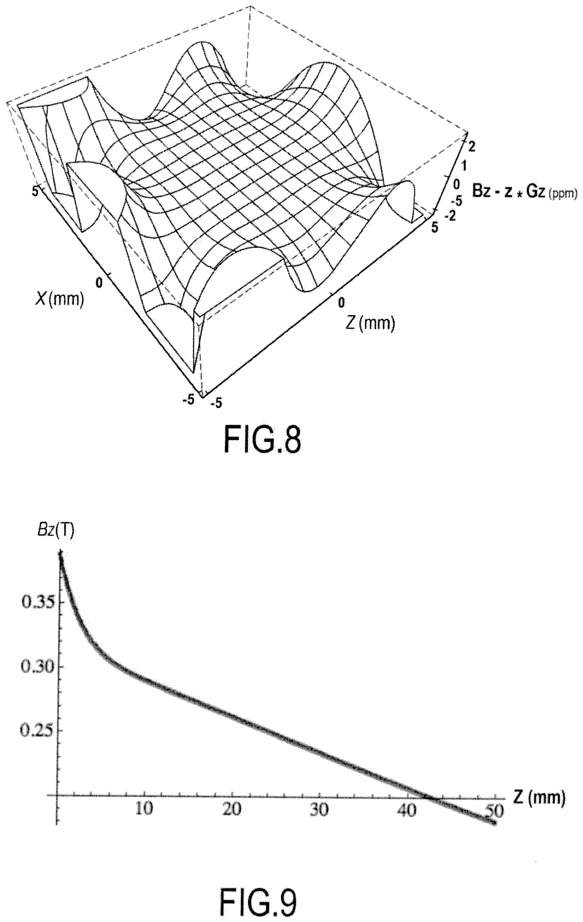

La figure 8 montre, pour les modes de réalisation précédemment décrits des figures 5 et 6, les variations de la composante $B_z$ du champ magnétique créé dans la zone d'intérêt au voisinage du centre d'homogénéité, dans un plan xOz contenant l'axe de symétrie, après élimination du gradient.

La figure 9 montre, pour les modes de réalisation précédemment décrits des figures 5 et 6, les variations de la composante $B_z$ du champ magnétique créé dans la zone d'intérêt au voisinage du centre d'homogénéité, le long de l'axe de symétrie z, en fonction de la distance à partir de la surface supérieure active du dispositif d'aimant 150 ou 250. On remarque d'après cette courbe le gradient presque parfait.

On décrira maintenant en référence à la figure 7 un autre mode de réalisation de l'invention qui consiste en un dispositif d'aimant 350 engendrant un champ magnétique extrêmement homogène.

Le dispositif de la figure 7 est très semblable aux dispositifs des figures 5 et 6 qui concernent des systèmes à gradient constant.

A titre d'exemple, on peut créer avec le dispositif de la figure 7 une zone d'homogénéité optimale 16 mm au-dessus de la surface supérieure du dispositif d'aimant 350 avec un champ homogène théorique variant de seulement quelques ppm dans une sphère de diamètre 8 mm.

La structure décrite à titre d'exemple comprend un ensemble 120 de trois structures aimantées coaxiales 121, 122, 123 ou anneaux placés au-dessus d'une structure de base 110 également en matériau magnétique qui, à la différence des structures de base 11 ou 12 des modes de réalisation des figures 5 et 6, présente du côté de la surface extérieure supérieure active une partie centrale en retrait 115 formant une cavité, dans laquelle est disposée au moins l'une des structures aimantées concentriques en forme de couronne divisée en éléments constitutifs en forme de secteurs non jointifs.

Sur la figure 7, on voit que l'anneau extérieur 123 est disposé sur la face périphérique supérieure de la structure de base 110 tandis que l'anneau intermédiaire 122 et l'anneau central 121 sont tous deux disposés à l'intérieur de la cavité 115 de façon légèrement décalée selon l'axe z par rapport à l'anneau extérieur 123. L'anneau central 121, qui peut être lui-même divisé en secteurs non jointifs et l'anneau intermédiaire 122 également divisé en secteurs non jointifs sont immobilisés dans la cavité 115 par des éléments mécaniques d'immobilisation classiques non représentés sur le dessin.

Les divers modes de réalisation décrits peuvent se combiner entre eux. Ainsi, par exemple, bien que l'on ait représenté sur la figure 7 une structure entièrement prismatique, le support de base 110, qui peut ou non être réalisé à partir de secteurs contigus, pourrait être cylindrique à section circulaire comme dans le mode de réalisation de la figure 6. Un ou plusieurs anneaux 121, 122, 123 de l'ensemble 120 pourraient également être réalisés avec des parois périphérique et interne cylindriques plutôt que prismatiques tout en restant divisés en secteurs non jointifs pour au moins l'un des anneaux, des espaces libres restant ménagés d'une part entre les secteurs non jointifs et d'autre part entre les divers anneaux pour permettre les ajustements nécessaires comme dans le cas des modes de réalisation constituant des systèmes à gradient constant.

La nature des matériaux utilisés et l'orientation de l'aimantation des pièces individuelles peuvent être choisies comme indiqué plus haut en référence aux modes de réalisation des figures 5 et 6.

Les structures présentées à titre d'exemple éliminent les termes du développement en harmoniques sphériques des ordres 2, 3, 4 et 5 et sont donc dominées par l'ordre 6.

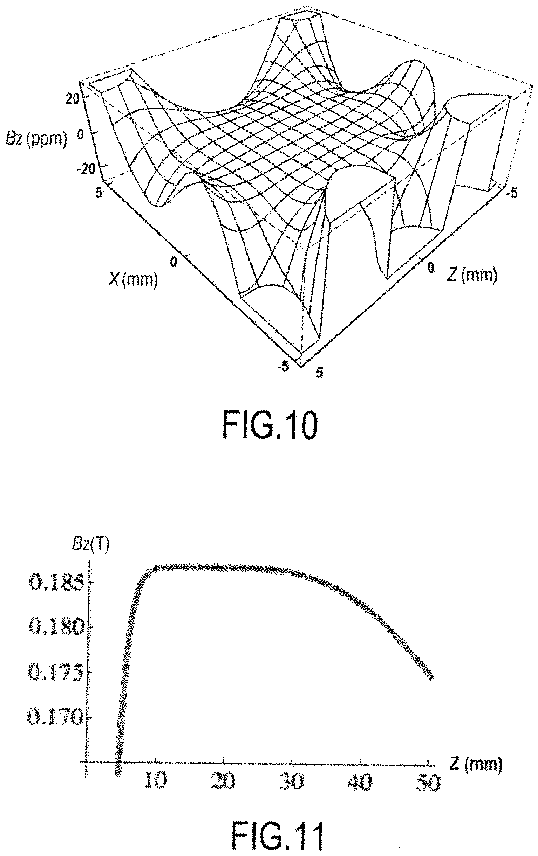

La figure 10 montre, pour le mode de réalisation précédemment décrit de la figure 7, les variations de la composante $B_z$ du champ magnétique créé dans la zone d'intérêt au voisinage du centre d'homogénéité, dans un plan xOz contenant l'axe de symétrie, après élimination du gradient.

La figure 11 montre, pour le mode de réalisation précédemment décrit de la figure 7, les variations de la composante $B_z$ du champ magnétique créé dans la zone d'intérêt au voisinage du centre d'homogénéité, le long de l'axe de symétrie z, en fonction de la distance à partir de la surface supérieure active du dispositif d'aimant 350. On remarque d'après cette courbe qu'il existe bien une zone de champ constant tandis que la valeur de l'induction change très rapidement en dehors de cette zone.

La conception du dispositif selon l'invention permet notamment de simuler les effets de démagnétisation ou d'aimantation aléatoire au sein de chaque pièce individuelle ainsi que des imperfections géométriques qui sont susceptibles de dégrader le profil du champ magnétique créé.

L'effet d'un petit déplacement d'un élément constitutif individuel, par exemple de forme trapézoïdale peut être calculé et l'on peut alors construire une matrice jacobienne. A partir de cette matrice, on peut calculer les déplacements requis pour corriger les imperfections, sous réserve que le système ne soit pas trop éloigné de la solution idéale et que le système puisse être considéré comme localement linéaire. Un résultat peut généralement être obtenu après quelques itérations. A titre d'exemple, les déplacements calculés ou simulés sont inférieurs à environ 2 mm et les corrections à apporter à la configuration initiale restent minimes. Le dispositif selon l'invention se prête donc très bien à la simulation et à la correction des petites imperfections de fabrication inévitables en pratique, ce qui permet la plupart du temps d'éviter, mais n'exclut pas d'utiliser en outre si nécessaire des procédés d'ajustement à l'aide de petites pièces additionnelles en matériau ferromagnétique ou en matière aimantée de façon permanente.

**Revendications**

1. Dispositif d'aimant permanent cylindrique pour produire le champ magnétique d'un appareil unilatéral de Résonance Magnétique Nucléaire et comprenant au moins une structure de base (10 ; 11 ; 12 ; 110) présentant un axe longitudinal (z) et un ensemble (20 ; 120) de structures aimantées coaxiales (21, 22, 23, 24 ; 121, 122, 123) en forme de couronnes non jointives ayant pour axe ledit axe longitudinal (z) et disposées d'un même côté de la structure de base en définissant une surface extérieure perpendiculaire audit axe longitudinal (z) pour produire ledit champ magnétique hors du dispositif d'aimant dans une zone d'intérêt extérieure (3) située à une distance prédéterminée de ladite surface extérieure le long de l'axe longitudinal (z), **caractérisé en ce que** l'une au moins des structures aimantées coaxiales (21, 22, 23, 24 ; 121, 122, 123) en forme de couronnes est divisée en éléments constitutifs en forme de secteurs identiques non jointifs et **en ce que** la structure de base (10 ; 11 ; 12 ; 110) et l'ensemble (20 ; 120) des structures aimantées coaxiales (21, 22, 23, 24 ; 121, 122, 123) en forme de couronnes sont aimantées selon une même direction de manière à induire dans ladite zone d'intérêt extérieure (3) ledit champ magnétique et de telle sorte que ledit champ magnétique soit homogène ou présente un gradient constant dans ladite zone d'intérêt extérieure (3) et permette d'effectuer des mesures de Résonance Magnétique Nucléaire sur un échantillon placé dans ladite zone d'intérêt extérieure.

2. Dispositif selon la revendication 1, **caractérisé en ce que** tous les éléments constitutifs en forme de secteurs sont aimantés selon ledit axe longitudinal (z) de telle sorte que ledit champ magnétique induit soit orienté selon ledit axe longitudinal (z).

3. Dispositif selon la revendication 1, **caractérisé en ce que** la structure de base (11 ; 110) présente une forme prismatique.

4. Dispositif selon l'une quelconque des revendications 1 à 3, **caractérisé en ce que** la structure de base (110) est divisée en secteurs identiques contigus.

5. Dispositif selon l'une quelconque des revendications 1 à 4, **caractérisé en ce que** l'ensemble (20 ; 120) de structures aimantées coaxiales (21, 22, 23, 24 ; 121, 122, 123) comprend une première structure centrale (21 ; 121), une structure intermédiaire (22) divisée en secteurs (61 à 72) identiques non jointifs régulièrement répartis et une structure extérieure (23 ; 123) divisée en secteurs (81 à 92) identiques non jointifs régulièrement répartis.

6. Dispositif selon l'une quelconque des revendications 1 à 5, **caractérisé en ce que** les structures aimantées coaxiales (22, 23 ; 121, 122, 123) divisées en secteurs non jointifs comprennent chacune au moins douze secteurs.

7. Dispositif selon l'une quelconque des revendications 1 à 6, **caractérisé en ce que** les diverses structures aimantées coaxiales (22, 23 ; 121, 122, 123) divisées en secteurs non jointifs présentent dans le sens de l'axe longitudinal (z) des épaisseurs différentes.

8. Dispositif selon l'une quelconque des revendications 1 à 7, **caractérisé en ce que** les diverses structures aimantées coaxiales (22, 23 ; 121, 122, 123) divisées en secteurs non jointifs présentent des positionnements à des niveaux différents le long de l'axe longitudinal (z).

9. Dispositif selon la revendication 5, **caractérisé en ce que** la première structure centrale (21) constitue un plot central monobloc.

10. Dispositif selon la revendication 9, **caractérisé en ce que** le plot central monobloc (21) est cylindrique à section circulaire.

**11.** Dispositif selon la revendication 9, **caractérisé en ce que** le plot central monobloc (21) est cylindrique à section polygonale.

**12.** Dispositif selon la revendication 5, **caractérisé en ce que** la première structure centrale (121) constitue un plot central en forme de couronne divisée en secteurs identiques non jointifs régulièrement répartis.

**13.** Dispositif selon l'une quelconque des revendications 1 à 12, **caractérisé en ce que** lesdits secteurs non jointifs présentent une forme trapézoïdale.

**14.** Dispositif selon l'une quelconque des revendications 1 à 13, **caractérisé en ce que** la structure de base (110) comprend du côté de la surface extérieure active une partie centrale en retrait (115) dans laquelle est disposée au moins une structure aimantée coaxiale (121, 122) en forme de couronne divisée en éléments constitutifs en forme de secteurs non jointifs, de telle manière que ledit champ magnétique induit soit homogène dans ladite zone d'intérêt extérieure (3).

**15.** Dispositif selon l'une quelconque des revendications 1 à 14, **caractérisé en ce que** la structure de base (10 ; 11 ; 12 ; 110) et l'ensemble des structures aimantées coaxiales (20 ; 120) sont réalisées en l'un des matériaux constitués par NdFeB et SmCo.

**Patentansprüche**

**1.** Zylindrische Dauermagnetvorrichtung zum Erzeugen des Magnetfelds eines einseitigen Kernspinresonanzgeräts, die mindestens eine Basisstruktur (10; 11; 12; 110) umfasst, die eine Längsachse (z) und eine Einheit (20; 120) koaxialer magnetisierter Strukturen (21, 22, 23, 24; 121, 122, 123) in Form von nicht aneinander stoßenden Kränzen aufweist, die als Achse die Längsachse (z) haben und auf ein und derselben Seite der Basisstruktur angeordnet sind, indem sie eine Außenoberfläche senkrecht zu der Längsachse (z) definieren, um das Magnetfeld außerhalb der Magnetvorrichtung in einem äußeren Interessensbereich (3) zu erzeugen, der in einer vorbestimmten Entfernung von der Außenoberfläche entlang der Längsachse (z) liegt, **dadurch gekennzeichnet, dass** mindestens eine der koaxialen magnetisierten Strukturen (21, 22, 23, 24; 121, 122, 123) in Form von Kränzen in Bestandselemente in Form identischer nicht aneinander stoßender Sektoren geteilt ist, und dass die Basisstruktur (10; 11; 12; 110) und die Einheit (20; 120) der koaxialen magnetisierten Strukturen (21, 22, 23, 24; 121, 122, 123) in Form von Kränzen entlang einer selben Richtung derart magnetisiert sind, dass sie in dem äußeren Interessensbereich (3) das Magnetfeld erzeugen, und derart, dass das Magnetfeld homogen ist oder ein konstantes Gefälle in dem äußeren Interessensbereich (3) aufweist und es erlaubt, Kernspinresonanzmessungen auf einer Probe, die in dem äußeren Interessensbereich platziert ist, auszuführen.

**2.** Vorrichtung nach Anspruch 1, **dadurch gekennzeichnet, dass** alle Bestandselemente in Form von Sektoren entlang der Längsachse (z) derart magnetisiert sind, dass das induzierte Magnetfeld entlang der Längsachse (z) ausgerichtet ist.

**3.** Vorrichtung nach Anspruch 1, **dadurch gekennzeichnet, dass** die Basisstruktur (11; 110) eine Prismenform aufweist.

**4.** Vorrichtung nach einem der Ansprüche 1 bis 3, **dadurch gekennzeichnet, dass** die Basisstruktur (110) in identische aneinander stoßende Sektoren geteilt ist.

**5.** Vorrichtung nach einem der Ansprüche 1 bis 4, **dadurch gekennzeichnet, dass** die Einheit (20; 120) koaxialer magnetisierter Strukturen (21, 22, 23, 24; 121, 122, 123) eine erste zentrale Struktur (21; 121), eine Zwischenstruktur (22), die in identische nicht aneinander stoßende Sektoren (61 bis 72), die regelmäßig verteilt sind, geteilt ist, und eine Außenstruktur (23; 123), die in identische nicht aneinander stoßende regelmäßig verteilte Sektoren (81 bis 92) geteilt ist.

**6.** Vorrichtung nach einem der Ansprüche 1 bis 5, **dadurch gekennzeichnet, dass** die koaxialen magnetisierten Strukturen (22, 23; 121, 122, 123), die in nicht aneinander bestoßende Sektoren geteilt sind, jeweils mindestens zwölf Sektoren umfassen.

**7.** Vorrichtung nach einem der Ansprüche 1 bis 6, **dadurch gekennzeichnet, dass** die diversen koaxialen magnetisierten Strukturen (22, 23; 121, 122, 123), die in nicht aneinander stoßende Sektoren geteilt sind, in die Richtung der Längsachse (z) unterschiedliche Stärken aufweisen.

8. Vorrichtung nach einem der Ansprüche 1 bis 7, **dadurch gekennzeichnet, dass** die diversen koaxialen magnetisierten Strukturen (22, 23; 121, 122, 123), die in nicht aneinander stoßende Sektoren geteilt sind, Positionierungen an unterschiedlichen Niveaus entlang der Längsachse (z) aufweisen.

9. Vorrichtung nach Anspruch 5, **dadurch gekennzeichnet, dass** die erste zentrale Struktur (21) einen einteiligen zentralen Klotz bildet.

10. Vorrichtung nach Anspruch 9, **dadurch gekennzeichnet, dass** der einteilige zentrale Klotz (21) zylindrisch mit kreisförmigem Querschnitt ist.

11. Vorrichtung nach Anspruch 9, **dadurch gekennzeichnet, dass** der einteilige zentrale Klotz (21) zylindrisch mit Vieleckquerschnitt ist.

12. Vorrichtung nach Anspruch 5, **dadurch gekennzeichnet, dass** die erste zentrale Struktur (121) einen zentralen Klotz mit Kranzform bildet, der in nicht aneinander stoßende regelmäßig verteilte identische Sektoren geteilt ist.

13. Vorrichtung nach einem der Ansprüche 1 bis 12, **dadurch gekennzeichnet, dass** die nicht aneinander stoßenden Sektoren eine Trapezform aufweisen.

14. Vorrichtung nach einem der Ansprüche 1 bis 13, **dadurch gekennzeichnet, dass** die Basisstruktur (110) auf der Seite der aktiven Außenoberfläche einen zentralen Teil (115) in Rücksprung umfasst, in dem mindestens eine koaxiale magnetisierte Struktur (121, 122) in Kranzform angeordnet ist, die in Bestandelemente in Form nicht aneinander stoßender Sektoren derart geteilt ist, dass das induzierte Magnetfeld in dem äußeren Interessensbereich (3) homogen ist.

15. Vorrichtung nach einem der Ansprüche 1 bis 14, **dadurch gekennzeichnet, dass** die Basisstruktur (10; 11; 12; 110) und die Einheit der koaxialen magnetisierten Strukturen (20; 120) aus einem der aus NdFeB und SmCo bestehenden Werkstoffe hergestellt sind.

**Claims**

1. A cylindrical permanent magnet device to produce the magnetic field of a unilateral nuclear magnetic resonance device and including at least one basic structure (10; 11; 12; 110) having a longitudinal axis (z) and a set (20; 120) of coaxial magnetized structures (21, 22, 23, 24; 121, 122, 123) that are in the form of non-contiguous rings of axis that is said longitudinal axis (z) and that are disposed on the same side of the basic structure, defining an exterior surface perpendicular to said longitudinal axis (z) to produce said magnetic field outside the magnet device in an exterior area of interest (3) situated at a predetermined distance from said exterior surface along the longitudinal axis (z), the permanent magnet device being **characterized in that** at least one of the coaxial magnetized structures (21, 22, 23, 24; 121, 122, 123) in the form of rings is divided into components in the form of non-contiguous identical sectors, and the basic structure (10; 11; 12; 110) and the set (20; 120) of coaxial magnetized structures (21, 22, 23, 24; 121, 122, 123) in the form of rings are magnetized in the same direction in order to induce said magnetic field in said exterior area of interest (3) so that the magnetic field is homogeneous or has a constant gradient in said exterior area of interest (3) and allows to perform measures of nuclear magnetic resonance on a sample placed in said exterior area of interest.

2. A device according to claim 1, **characterized in that** said predetermined angle is zero and all the components in the form of sectors are magnetized along said longitudinal axis (z) so that the magnetic field is oriented along said longitudinal axis (z) .

3. A device according to claim 1, **characterized in that** the basic structure (11; 110) is prism-shaped.

4. A device according to any one of claims 1 to 3, **characterized in that** the basic structure (110) is divided into contiguous identical sectors.

5. A device according to any one of claims 1 to 4, **characterized in that** the set (20; 120) of coaxial magnetized structures (21, 22, 23, 24; 121, 122, 123) comprises a central first structure (21; 121), an intermediate structure (22) divided into regularly distributed non-contiguous identical sectors (61 to 72), and an exterior structure (23; 123) divided into the regularly distributed non-contiguous identical sectors (81 to 92).

6. A device according to any one of claims 1 to 5, **characterized in that** each of the coaxial magnetized structures (22, 23; 121, 122, 123) divided into non-contiguous sectors comprises at least twelve sectors.

7. A device according to any one of claims 1 to 6, **characterized in that** the coaxial magnetized structures (22, 23; 121, 122, 123) divided into non-contiguous sectors have different thicknesses in the direction of the longitudinal axis (z).

8. A device according to any one of claims 1 to 7, **characterized in that** the coaxial magnetized structures (22, 23; 121, 122, 123) divided into non-contiguous sectors are positioned at different levels along the longitudinal axis (z).

9. A device according to claim 5, **characterized in that** the central first structure (21) constitutes a one-piece central block.

10. A device according to claim 9, **characterized in that** the one-piece central block (21) is cylindrical with a circular section.

11. A device according to claim 9, **characterized in that** the one-piece central block (21) is cylindrical with a polygonal section.

12. A device according to claim 5, **characterized in that** the central first structure (121) constitutes a central block in the form of a ring divided into regularly distributed non-contiguous identical sectors.

13. A device according to any one of claims 1 to 12, **characterized in that** said non-contiguous sectors have a trapezoidal shape.

14. A device according to any one of claims 1 to 13, **characterized in that**, on the side of the active exterior surface, the basic structure (110) has a recessed central part (115) in which there is disposed at least one coaxial magnetized structure (121, 122) in the form of a ring divided into components in the form of non-contiguous sectors so that said induced magnetic field is homogeneous in said exterior area of interest.

15. A device according to any one of claims 1 to 14, **characterized in that** the basic structure (10; 11; 12; 110) and the set of coaxial magnetized structures (20; 120) are produced in NdFeB or SmCo.

FIG.1A

FIG.1B

FIG.2

FIG.3

FIG.4

FIG.7

**FIG.5**

150

21

22

23

11

**FIG.6**

250

21

22

23

12

**FIG.8**

**FIG.9**

FIG.10

FIG.11

**EP 2 470 921 B1**

### RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6489872 B
- US 6828892 B
- WO 9905531 A
- WO 9915914 A
- WO 0057435 A
- US 5332971 A
- US 5134374 A
- WO 02056047 A
- US 6657433 B
- WO 0079253 A
- US 6489767 B